# EUROPEAN PATENT SPECIFICATION

(11) **EP 2 565 913 B1**
(45) Date of publication and mention of the grant of the patent: **20.03.2019**
(21) Application number: 11789258.8
(22) Date of filing: 22.06.2011
(51) Int. Cl.: H01L 21/56, H01L 23/31, B29C 39/42, H01L 25/16

(54) **METHOD FOR ENCAPSULATING OF A SEMICONDUCTOR**
VERFAHREN ZUR EINKAPSELUNG EINES HALBLEITERS
PROCÉDÉ D'ENCAPSULATION DE SEMI-CONDUCTEUR

(43) Date of publication of application: 06.03.2013
(73) Proprietor: Huawei Device Co., Ltd., Dongguan, Guangdong 523808 (CN)
(72) Inventor: YANG, Xiong, Shenzhen Guangdong 518129 (CN)
(74) Representative: Maiwald Patent- und Rechtsanwaltsgesellschaft mbH
(86) International application number: PCT/CN2011/076087
(87) International publication number: WO 2011/150879

(56) References cited:
- EP-A1- 1 198 005
- WO-A1-2005/067029
- CN-A- 101 110 406
- CN-A- 101 110 406
- CN-A- 101 611 483
- US-A- 5 105 259
- US-A1- 2008 251 901
- US-A1- 2009 298 228

## Description

### FIELD OF THE INVENTION

The present invention relates to a plastic encapsulation technology field, and in particular, to a method for encapsulating a component with plastic and a structure thereof.

### BACKGROUND OF THE INVENTION

Currently, the plastic encapsulation technique is widely used in the IC (Integrated Circuit, integrated circuit) industry to enclose and solidate a semiconductor in an epoxy resin material, thereby meeting the requirement for reliability and other protection requirements.

The prior art uses a one-step molding method: fix a component on a first surface and a second surface of a substrate to form a part to be encapsulated with plastic; place the part to be encapsulated with plastic in a mould cavity of a lower mold; hold the second surface of the part to be encapsulated with plastic with supports; combine the upper and lower molds; fill the first surface with resin through the glue injection hole on the upper mold; after resin filling is complete, solidate and mold the first surface at one time to complete plastic injection on the first surface of the part to be encapsulated with plastic.

The prior art has at least the following problem: The substrate is bent at certain parts due to gravity of the substrate and component or distortion of the substrate. Therefore, during plastic injection on the first surface, the second surface of the part to be encapsulated with plastic needs to reserve a large room for support to help support the mold and prevent local bending or distortion of the substrate. The large room for support occupies a layout space on the component. Nevertheless, the space of the support plane is insufficient, and the substrate still suffers inevitable distortion possibility. To further prevent distortion, the substrate needs to be properly thickened.

US 2009/0298228 A1 relates to a method for manufacturing a semiconductor device. A resin layer made of thermoplastic resin is formed on a supporting substrate, and then, an insulating layer is formed on the first resin layer. Then, an interlayer connector is formed through the insulating layer and then, a wiring layer is formed on the first resin layer so as to be electrically connected with the interlayer connector. Thereafter, a first semiconductor chip is mounted on the wiring layer. Then, the first resin layer is heated so that the supporting substrate and the insulating layer are relatively shifted one another to shear the first resin layer, thereby separating the supporting substrate and the insulating layer and forming a semiconductor device.

WO 2005 067029 A1 relates to a method for packaging integrated circuit dies. Two substrates each carrying at least one die are placed back-to-back in a mould with their surfaces which carry dies facing into respective cavities. Each cavity is fed liquid resin through at least one respective channel which introduces the resin into the cavity at a location spaced from the corresponding substrate. Thus a resin body is formed on each of the substrates. Thus, a package is produced from each of the two substrates in a single moulding operation. The method described in this document is particularly suitable for producing flip-chip-in-package-type packages.

EP 1 198 005 A1 relates to semiconductor module and method of mounting. A multiple-chip module comprising a plurality of semiconductor chips such as bare chips and packaged chips mounted on a circuit board. The semiconductor chips are covered with a heat sink on top, and the gaps between the heat sink and the circuit board are filled with resin. Since the semiconductor chips are bonded together by the resin to disperse stresses that some chips may suffer, the chips and the heat sink can be protected from damage due to the concentration of stresses. The resin between the semiconductor chips and the heat sink makes the contact between them easy even if the chips have different sizes. Further, all the chips and the heat sink are bonded in a single process.

US 5 105 259 A relates to thermally enhanced semiconductor device utilizing a vacuum to ultimately enhance thermal dissipation. A semiconductor device having a heat sink is provided in which an opening through the heat sink enables a vacuum source to be applied to a semiconductor die mounted surface. In one form, a semiconductor die is attached to a mounting surface of a leadframe. The leadframe also has a plurality of leads which are electrically coupled to the semiconductor die. The semiconductor die and portions of the leads encapsulated in a package body. Also incorporated in the package body is a heat sink. The heat sink has an opening which extends through the heat sink and exposes a portion of the mounting
surface of the leadframe. The opening is used to apply a vacuum to the mounting surface during the formation of the package body so that the mounting surface and heat sink are held in close proximity. The closeness provides a good thermal conduction path from the semiconductor die to the ambient, thereby enhancing the thermal dissipation properties of the device.

CN 101 110 406 A discloses a method to bond two dies on opposite sides of a substrate. A first die is bonded on a first surface of a substrate and encapsulated with moulding resin. A layer on the other side of the substrate is then removed to expose a second surface of the substrate. Next, a second die is bonded on the second surface of the substrate. This die is finally encapsulated with moulding resin as well.

CN 101 611 483 A also discloses a die encapsulation method.

US 2008 251 901 A1 discloses a method to fabricate an integrated circuit package from two dies and one lead-frame with a die paddle having a first surface and a second surface. A first die is fixed on the first surface die paddle, connected to the lead-frame and encapsulated with plastic. The lead-frame is then flipped over. Next, a second die is fixed on the second surface of the die paddle, connected to the lead-frame and encapsulated with plastic as well.

### SUMMARY OF THE INVENTION

The purpose of the embodiments of the present invention is to provide a method that is able to solve the problem of warpage on the part to be encapsulated with plastic according to the problem in the prior art.

Another purpose of the embodiments of the present invention is to provide an encapsulation structure for encapsulating a component with plastic.

To achieve the preceding purposes, the present invention adopts the following technical solutions: a method for encapsulating a component with plastic, said part having a first surface and a second surface, including:
first, step 101: processing the first surface of the part to be encapsulated with plastic by using the surface mounting technology on the first surface; and after step 101 is performed,
step 102: encapsulating, with plastic, the first surface of the part to be encapsulated with plastic which has undergone the processing performed by using the surface mounting technology on the first surface; and after step 102 is performed,
step 103: processing the second surface of the part to be encapsulated with plastic, the first surface of which has undergone the encapsulating with plastic, by using the surfact mounting technology; and after step 103 is performed,
step 104: encapsulating, with plastic, the second surface of the part to be encapsulated with plastic which has undergone the processing performed by using the surface mounting technology on the second surface.

A specific step of the encapsulating the first surface with plastic comprises:
placing the part to be encapsulated with plastic in a mould cavity of a lower mold, wherein the first surface of the part is processed by using the surface mounting technology on the first surface, and combining an upper mold and the lower mold;
vacuuming the second surface through a vacuum suction hole at the bottom of the lower mold to keep the plane of the second surface smooth; and
injecting resin to the first surface through a resin injection hole on the upper mold and finally solidating the first surface,
and wherein a specific step of the encapsulating the second surface with plastic comprises:
   placing the part to be encapsulated with plastic in the mould cavity of the lower mold, wherein the second surface of the part is processed by using the surface mounting technology on the second surface, placing the second surface of the part to be encapsulated with plastic under the resin injection hole on the upper mold, and combining the upper mold and the lower mold;
   vacuuming the bottom of the first surface plastic that is encapsulated with plastic through the vacuum suction hole at the bottom of the lower mold to keep the plane of the bottom of the first surface plastic that is encapsulated with plastic smooth; and
   injecting resin to the second surface through the resin injection hole on the upper mold and finally solidating the second surface.

Another technical solution provided in an embodiment of the present invention is: an

### BRIEF DESCRIPTION OF THE DRAWINGS

To make the technical solution of the present invention clearer, the accompanying drawings for illustrating the embodiments of the present invention or the prior art are briefly described below. Apparently, the accompanying drawings are for the exemplary purpose only, and those skilled in the art are able to derive other drawings from such accompanying drawings
FIG. 1 is a flowchart of a technique according to an embodiment of the present invention;
FIG. 2 is a structural schematic diagram of an upper fixing component on a single-surface substrate according to an embodiment of the present invention;
FIG. 3 is a structural schematic diagram of performing plastic encapsulation on a single-surface substrate according to an embodiment of the present invention;
FIG. 4 is a structural schematic diagram after single-surface encapsulation according to an embodiment of the present invention;
FIG. 5 is a structural schematic diagram for dual-surface encapsulation according to an embodiment of the present invention;
FIG. 6 is a structural schematic diagram after dual-surface encapsulation according to an embodiment of the present invention;
FIG. 7 is a structural schematic diagram after plastic encapsulation by using dispensing for plastic encapsulation of the second surface according to an embodiment of the present invention; and
FIG. 8 is a structural schematic diagram where a surface of seal is in a step-like form according to an embodiment of the present invention.

In the figures: 1 indicates component, 2 substrate, 3 mold, 3.1 upper mold, 3.2 lowe rmold, 4 glue injection hole, 5 seal, 6 vacuum suction hole.

### DETAILED DESCRIPTION OF THE EMBODIMENTS

To clarify the purpose, technical scheme, and advantages of the embodiments of the present invention, the following describes the embodiments of the present invention with drawings.

### Embodiment 1

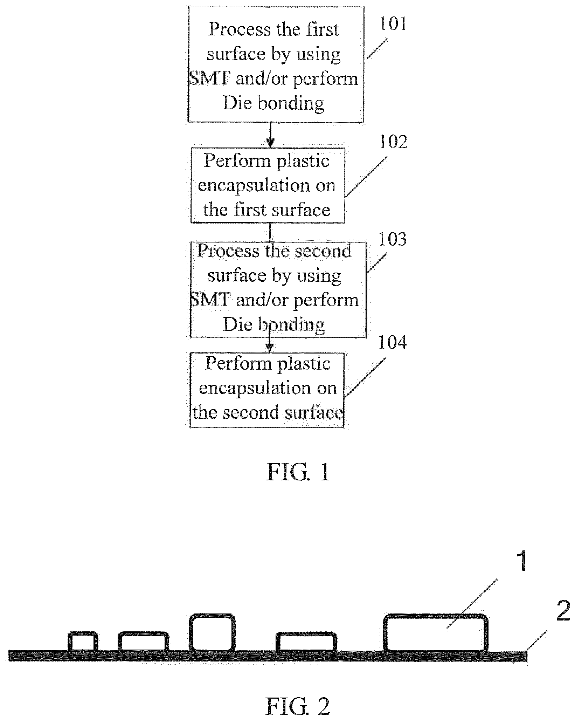

As shown in FIG. 1, a method for encapsulating a component with plastic includes the following steps:
Step 101: Process, by using the SMT (Surface Mounting Technology), a first surface and/or performing Die bonding on the first surface: Process, by using the surface mounting technology, the first surface of a part to be encapsulated with plastic and/or performing die bonding on the first surface.
Step 102: Encapsulate the first surface with plastic: Encapsulate, with plastic, the first surface of the part to be encapsulated with plastic which has undergone the processing performed by using the surface mounting technology and/or has undergone the die bonding.
Step 103: Process a second surface by using the SMT and/or performing Die bonding on the second surface: Process, by using the SMT, the second surface of the part to be encapsulated with plastic the first surface of which has undergone the encapsulating with plastic and/or perform Die bonding on the second surface.
Step 104: Encapsulate the second surface with plastic: Encapsulate, with plastic, the second surface of the part to be encapsulated with plastic which has undergone the processing performed by using the surface mounting technology and/or has undergone the die bonding.

In the method for encapsulating a component with plastic provided in an embodiment of the present invention, the component that does not assemble the second surface during plastic encapsulation of the first surface uses the entire second surface as a support plane without the need of separate supports, solves the problem of warpage and distortion of the substrate. By using the method according to this embodiment, as warpage factors do not need to be considered, the overall thickness of the substrate is able to be reduced, and components encapsulated with plastic are able to be deployed on both surfaces, thereby increasing the component layout density.

### Embodiment 2

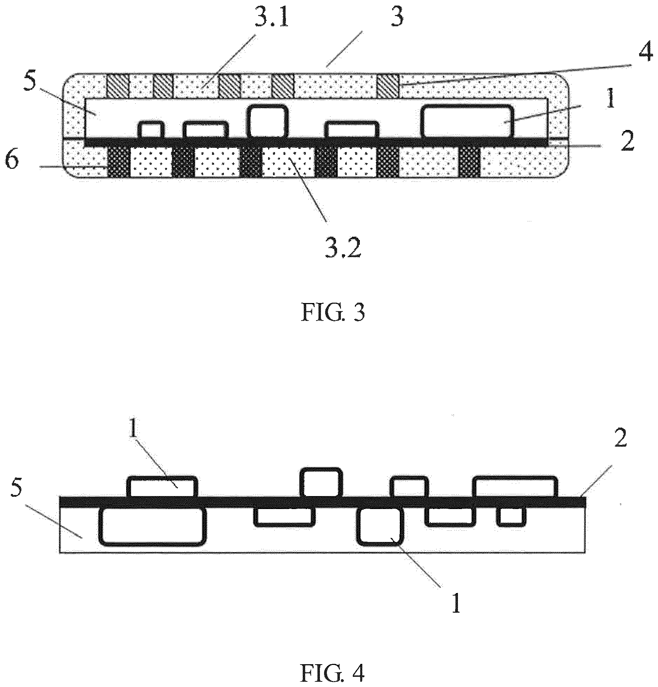

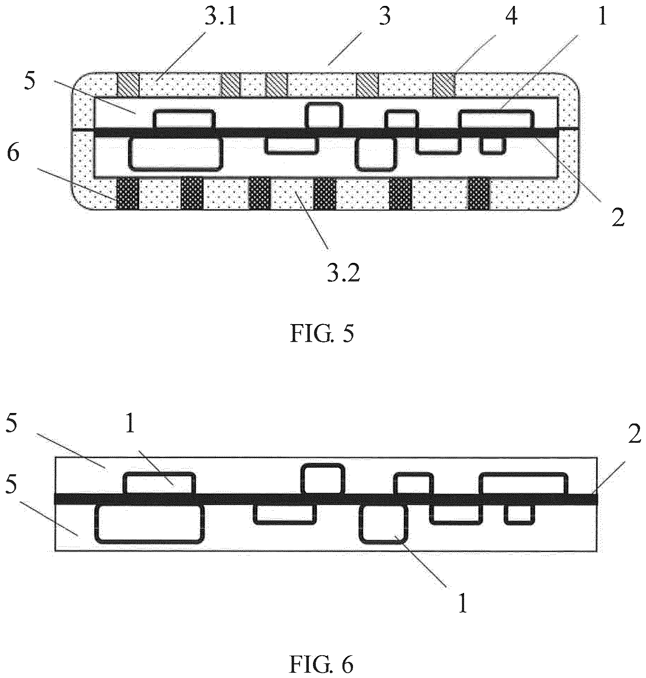

As shown in FIG. 1, a method for encapsulating a component with plastic includes the following steps:
Step 101: As shown in FIG. 2, process a first surface by using the SMT: Complete work procedures for a single surface, such as solder paste printing, pasting, and reflow, so that a component 1 is fixed on the front surface of a substrate 2; or perform Die bonding.
Step 102: As shown in FIG. 3, encapsulate the first surface with plastic: Place a part to be encapsulated with plastic the first surface of which is processed in a mould cavity of a mold 3; combine an upper mold 3.1 and a lower mold 3.2; vacuum the bottom of the substrate 2 through a vacuum suction hole 6 at the bottom of the lower mold 3.2; inject glue through a glue injection hole 4; perform solidation so that the component 1 on the substrate 2 is encapsulated with plastic by using a seal 5.
Step 103: As shown in FIG. 4, process a second surface with SMT: Complete work procedures for a second surface, such as solder paste printing, pasting, and reflow, so that the component 1 is fixed on the back surface of the substrate 2; or perform Die bonding.
Step 104: As shown in FIG. 5, encapsulate the second surface with plastic: Place the part to be encapsulated with plastic the second surface of which is processed in the mould cavity of mold 3; place the second surface of the part to be encapsulated with plastic under the glue injection hole 4; combine the upper mold 3.1 and the lower mold 3.2; vacuum the bottom of the first surface that is encapsulated with plastic through the vacuum suction hole 6 at the bottom of the lower mold 3.2 to keep a smooth plane; after injecting glue through the glue injection hole 4, perform solidation so that the component 1 on the front and back surfaces of the substrate 2 is encapsulated with plastic by using the seal 5.

In the method for encapsulating a component with plastic provided in an embodiment of the present invention, the entire second surface is used as the support plane during plastic encapsulation of the first surface without the need of separate supports, thereby solves the problem of warpage and distortion of the substrate; as warpage factors do not need to be considered, the overall thickness of the substrate is able to be reduced, and components encapsulated with plastic are able to be deployed on both surfaces, thereby increasing the component layout density; compared with the one-step molding mode, the use of plastic encapsulation molds requires no support and a lower cost. Dual-surface plastic encapsulation technique may be directly used to replace a plastic or metal shell of a traditional product (other electronic products such as mobile phone).

### Embodiment 3

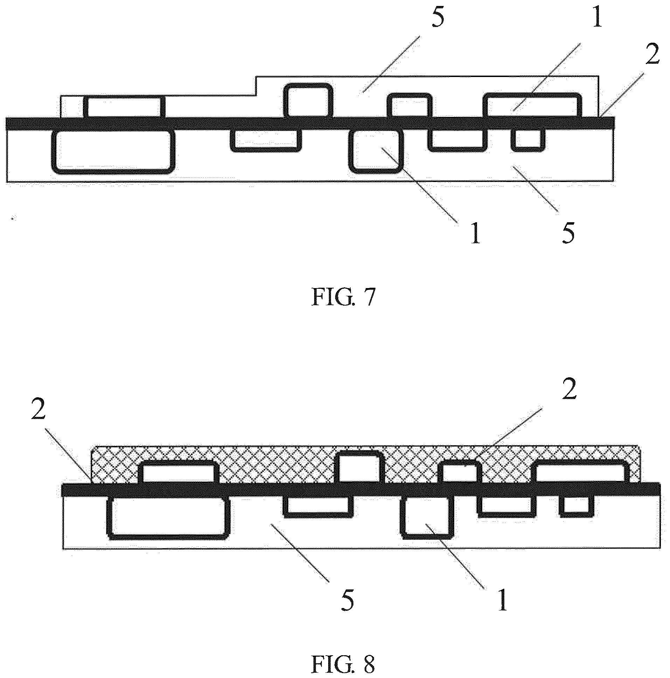

As shown in FIG. 7, this embodiment is based on Embodiment 2, and changes the manner by using which a second surface is encapsulated with plastic into a dispensing manner in which molds are not used to inject plastic. Mould opening is not required in the operation, which has the advantage of easy operation.

FIG. 6 shows an encapsulation structure for encapsulating a component with plastic, including a substrate 2, where components 1 are fixed on both an upper surface and a lower surface of the substrate 2, and the components 1 on the upper surface and lower surface are both encapsulated with plastic in a seal 5.

The dual-surface plastic encapsulation of the component in this embodiment endows both surfaces with characteristics such as dustproof and waterproof, and good internal sealability.

As shown in FIG. 8, the upper surface and/or lower surface of the seal 5 are in a step-like form. Preferably, one surface of the seal 5 is in the step-like form.

When the first surface of the seal is in the step-like form, during sealing for the second surface, a surface of an internal cavity of the lower mould may also be made into a step-like form corresponding to the first surface, thereby helping vacuum the lower surface of the first surface to keep a smooth plane.

The component in this embodiment may be an active/passive component such as a resistor, a capacitor, and/or a raw wafer.

The seal in this embodiment is epoxy resin.

## Claims

1. A method for encapsulating a part (1) with plastic, said part (1) having a first surface and a second surface, comprising:
first, step 101: processing (101) the first surface of the part (1) to be encapsulated with plastic by using the surface mounting technology on the first surface; and after step 101 is performed,
step 102: encapsulating (102), with plastic, the first surface of the part (1) to be encapsulated with plastic; and after step 102 is performed,
step 103: processing (103) the second surface of the part (1) to be encapsulated with plastic by using the surface mounting technology; and after step 103 is performed,
step 104: encapsulating (104), with plastic, the second surface of the part (1) to be encapsulated with plastic,
wherein a specific step (102) of the encapsulating the first surface with plastic comprises:
placing the part to be encapsulated with plastic in a mould cavity of a lower mold (3.2), and combining an upper mold (3.1) and the lower mold (3.2);
vacuuming the second surface through a vacuum suction hole (6) at the bottom of the lower mold (3.2) to keep the plane of the second surface smooth; and
injecting resin to the first surface through a resin injection hole (4) on the upper mold (3.1) and finally solidating the first surface,
and wherein a specific step (104) of the encapsulating the second surface with plastic comprises:
placing the part (1) to be encapsulated with plastic in the mould cavity of the lower mold (3.2), placing the second surface of the part to be encapsulated with plastic under the resin injection hole (4) on the upper mold (3.1), and combining the upper mold (3.1) and the lower mold (3.2);
vacuuming the bottom of the first surface that is encapsulated with plastic through the vacuum suction hole (6) at the bottom of the lower mold (3.2) to keep the plane of the bottom of the first surface that is encapsulated with plastic smooth; and
injecting resin to the second surface through the resin injection hole (4) on the upper mold (3.1) and finally solidating the second surface.

2. The method for encapsulating a part (1) with plastic according to claim 1, wherein a specific step of the encapsulating the second surface with plastic comprises: using a dispensing manner for encapsulating the second surface with plastic.

## Patentansprüche

1. Verfahren zur Einkapselung eines Teils (1) mit Kunststoff, wobei das Teil (1) eine erste Oberfläche und eine zweite Oberfläche aufweist, umfassend:
zuerst Schritt 101: Aufbereitung (101) der ersten Oberfläche des mit Kunststoff einzukapselnden Teils (1) durch Anwendung der Oberflächenmontagetechnik auf der ersten Oberfläche; und nach Durchführung von Schritt 101,
Schritt 102: Einkapselung (102) der ersten Oberfläche des mit Kunststoff einzukapselnden Teils (1) mit Kunststoff; und nach Durchführung von Schritt 102,
Schritt 103: Aufbereitung (103) der zweiten Oberfläche des mit Kunststoff einzukapselnden Teils (1) durch Anwendung der Oberflächenmontagetechnik; und
nach Durchführung von Schritt 103,
Schritt 104: Einkapselung (104) der zweiten Oberfläche des mit Kunststoff einzukapselnden Teils (1) mit Kunststoff,
wobei ein bestimmter Schritt (102) der Einkapselung der ersten Oberfläche mit Kunststoff das Folgende umfasst:
Platzieren des mit Kunststoff einzukapselnden Teils in einen Formhohlraum einer unteren Form (3.2),
und Zusammenbringen einer oberen Form (3.1) und der unteren Form (3.2);
Anlegen eines Vakuums an die zweite Oberfläche durch ein Vakuumsaugloch (6) an der Unterseite der unteren Form (3.2), um die Ebene der zweiten Oberfläche glatt zu halten; und
Einspritzen von Harz auf die erste Oberfläche durch ein Harzeinspritzloch (4) auf der oberen Form (3.1) und schließlich Verfestigen der ersten Oberfläche,
und wobei ein bestimmter Schritt (104) der Einkapselung der zweiten Oberfläche mit Kunststoff das Folgende umfasst:
Platzieren des mit Kunststoff einzukapselnden Teils (1) in den Formhohlraum der unteren Form (3.2),
Platzieren der zweiten Oberfläche des mit Kunststoff einzukapselnden Teils unter dem Harzeinspritzloch (4) auf der oberen Form (3.1),
und Zusammenbringen der oberen Form (3.1) und der unteren Form (3.2);
Anlegen eines Vakuums an die Unterseite der ersten Oberfläche, die mit Kunststoff eingekapselt ist, durch das Vakuumsaugloch (6) an der Unterseite der unteren Form (3.2), um die Ebene der Unterseite der ersten Oberfläche, die mit Kunststoff eingekapselt ist, glatt zu halten; und
Einspritzen von Harz auf die zweite Oberfläche durch das Harzeinspritzloch (4) auf der oberen Form (3.1) und schließlich Verfestigen der zweiten Oberfläche.

2. Verfahren zur Einkapselung eines Teils (1) mit Kunststoff nach Anspruch 1, wobei ein bestimmter Schritt der Einkapselung der zweiten Oberfläche mit Kunststoff das Folgende umfasst: Verwendung einer Spendertechnik zur Einkapselung der zweiten Oberfläche mit Kunststoff.

## Revendications

1. Procédé pour encapsuler une pièce (1) avec du plastique, ladite pièce (1) ayant une première surface et une seconde surface, comprenant :
d'abord, l'étape 101 : consistant à traiter (101) la première surface de la pièce (1) qui doit être encapsulée avec du plastique en utilisant la technologie de montage en surface sur la première surface ; et après que l'étape 101 est réalisée,
l'étape 102 : consistant à encapsuler (102), avec du plastique, la première surface de la pièce (1) qui doit être encapsulée avec du plastique ; et après que l'étape 102 est réalisée,
l'étape 103 : consistant à traiter (103) la seconde surface de la pièce (1) qui doit être encapsulée avec du plastique en utilisant la technologie de montage en surface ; et après que l'étape 103 est réalisée,
l'étape 104 ; consistant à encapsuler (104), avec du plastique, la seconde surface de la pièce (1) qui doit être encapsulée avec du plastique,
dans lequel une étape spécifique (102) de l'encapsulation de la première surface avec du plastique consiste :
à placer la pièce qui doit être encapsulée avec du plastique dans une cavité de moule d'un moule inférieur (3.2),
et à combiner un moule supérieur (3.1) et le moule inférieur (3.2) ;
à mettre sous vide la seconde surface par un trou d'aspiration sous vide (6) au fond du moule inférieur (3.2) pour garder le plan de la seconde surface lisse ; et
à injecter une résine sur la première surface par un trou d'injection de résine (4) sur le moule supérieur (3.1) et, finalement, à solidifier la première surface,
et dans lequel une étape spécifique (104) de l'encapsulation de la seconde surface avec du plastique consiste :
à placer la pièce (1) qui doit être encapsulée avec du plastique dans la cavité de moule du moule inférieur (3.2),
à placer la seconde surface de la pièce qui doit être encapsulée avec du plastique sous le trou d'injection de résine (4) sur le moule supérieur (3.1) et à combiner le moule supérieur (3.1) et le moule inférieur (3.2) ;
à mettre sous vide la partie inférieure de la première surface qui est encapsulée avec du plastique par le trou d'aspiration sous vide (6) au fond du moule inférieur (3.2) pour garder le plan de la partie inférieure de la première surface qui est encapsulée avec du plastique, lisse ; et
à injecter une résine sur la seconde surface par le trou d'injection de résine (4) sur le moule supérieur (3.1) et, finalement, à solidifier la seconde surface.

2. Procédé pour encapsuler une pièce (1) avec du plastique selon la revendication 1, dans lequel une étape spécifique de l'encapsulation de la seconde surface avec du plastique consiste : à utiliser une manière de distribution pour encapsulation la seconde surface avec du plastique.
